Europäisches Patentamt

European Patent Office

Office européen des brevets

(19)

(11)  **EP 1 244 206 A1**

(12)  **DEMANDE DE BREVET EUROPEEN**

(43) Date de publication:
**25.09.2002   Bulletin 2002/39**

(51) Int Cl.⁷: **H03D 3/00**

(21) Numéro de dépôt: **02364014.7**

(22) Date de dépôt: **18.03.2002**

(84) Etats contractants désignés:
**AT BE CH CY DE DK ES FI FR GB GR IE IT LI LU MC NL PT SE TR**
Etats d'extension désignés:
**AL LT LV MK RO SI**

(30) Priorité: **21.03.2001  FR 0103794**

(71) Demandeur: **STMicroelectronics
92120 Montrouge (FR)**

(72) Inventeur: **Garcia, Luc
56100 Lorient (FR)**

(74) Mandataire: **Bentz, Jean-Paul et al
Cabinet Ballot
4 rue du Général Hoche
BP 855
56100 Lorient (FR)**

(54) **Cicuit multiplicateur de signaux sinusoidaux**

(57)     La présente invention concerne un circuit multiplicateur de signaux sinusoïdaux apte à produire un signal sinusoïdal de sortie dépourvu de composante continue. Selon l'invention, il comporte une première cellule de multiplication (C1) recevant sur une première entrée (E1) un premier signal sinusoïdal (S1(t)) et sur une deuxième entrée (E2) un second signal sinusoïdal (S2(t)), ladite première cellule de multiplication délivrant un premier signal de sortie (O1(t)), une seconde cellule de multiplication (C2) identique à la première cellule de multiplication (C1) recevant sur sa première entrée (E1) le second signal sinusoïdal (S2(t)) et sur sa deuxième entrée (E2) le premier signal sinusoïdal (S1(t)) et délivrant un second signal de sortie (O2(t)), et un circuit additionneur (ADD) pour additionner lesdits premier et second signaux de sortie afin de générer un signal de sortie dépourvu de composante continue.

Application : démodulateurs FM analogiques.

FIG.2

Printed by Jouve, 75001 PARIS (FR)

## Description

La présente invention concerne un circuit multiplicateur de signaux sinusoïdaux. L'invention trouve par exemple son application dans le domaine des démodulateurs FM analogiques.

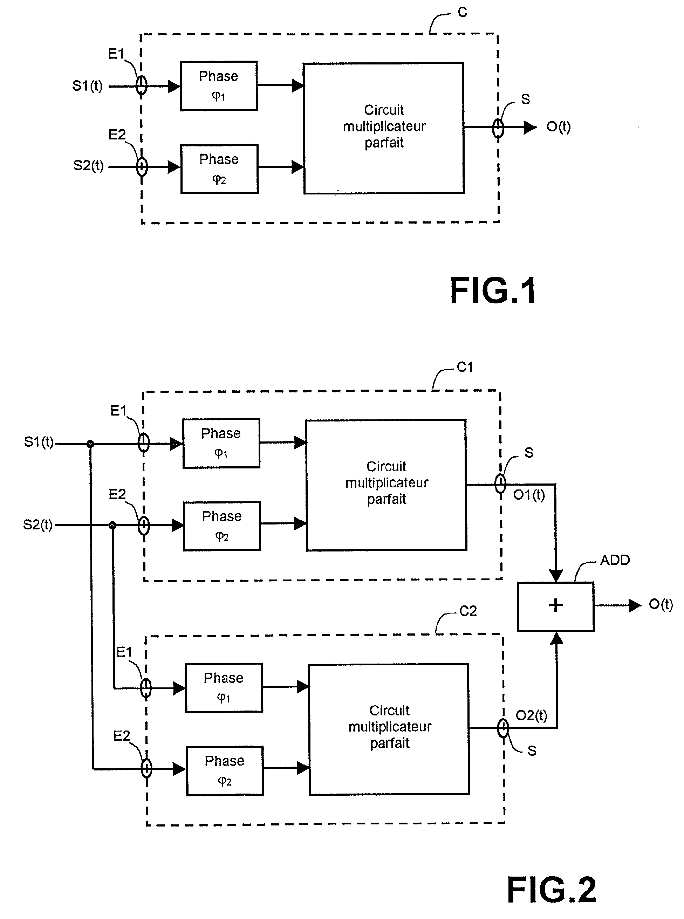

Les circuits multiplicateurs couramment employés pour multiplier des signaux sinusoïdaux sont des cellules asymétriques présentant un décalage de phase entre leurs entrées. Une cellule de multiplication asymétrique peut être modélisée sous la forme d'un circuit multiplicateur parfait à deux entrées ayant sur chacune de ses entrées un élément introduisant un retard de phase. Une telle modélisation est montrée à la figure 1. La cellule de multiplication, référencée C, comporte deux entrées E1 et E2 recevant des signaux sinusoïdaux, S1(t) et S2(t), et une sortie S délivrant un signal sinusoïdal O(t). Dans cette cellule, les signaux d'entrée S1(t) et S2(t) sont décalés en phase par des éléments de retard de phase introduisant respectivement un retard de phase $\varphi1$ et $\varphi2$, puis multipliés par un circuit multiplicateur parfait. Si on fournit aux entrées E1 et E2 de la cellule de multiplication respectivement les signaux suivants S1(t) $=A_1$*cos(wt) et S2(t)=$A_2$*sin(wt), on obtient à la sortie de la cellule de multiplication le signal O(t) suivant:

$$O(t)=A_1A_2*\cos(wt-\varphi1)*\sin(wt-\varphi2)$$

$$=(A_1A_2/2)*\sin(2wt-\varphi1-\varphi2) + (A_1A_2/2)*\sin(\varphi1-\varphi2)$$

Le signal de sortie O(t) comporte une composante sinusoïdale $(A_1A_2/2)$*sin(2wt-$\varphi1$-$\varphi2$) et une composante continue $(A_1A_2/2)$*sin($\varphi1$-$\varphi2$) correspondant à un décalage ("offset" en langue anglaise) en amplitude du signal de sortie.

Un but de l'invention est de proposer un circuit multiplicateur apte à délivrer un signal de sortie dépourvu de composante continue.

L'invention a donc pour objet un circuit multiplicateur de signaux sinusoïdaux apte à produire un signal sinusoïdal de sortie dépourvu de composante continue, comportant une première cellule de multiplication recevant sur une première entrée un premier signal sinusoïdal et sur une deuxième entrée un second signal sinusoïdal, ladite première cellule de multiplication délivrant un premier signal de sortie, caractérisé en ce qu'il comporte en outre:

- une seconde cellule de multiplication identique à la première cellule de multiplication recevant sur sa première entrée le second signal sinusoïdal et sur sa deuxième entrée le premier signal sinusoïdal et délivrant un second signal de sortie, et
- un circuit additionneur pour additionner lesdits premier et second signaux de sortie afin de générer un signal de sortie dépourvu de composante continue.

Cette caractéristique et les différents avantages de l'invention apparaîtront à la lecture de la description détaillée qui suit et qui est faite en référence aux dessins annexés, parmi lesquels :

- la figure 1, déjà décrite, représente une modélisation d'une cellule de multiplication classique; et
- la figure 2 représente un mode de réalisation du circuit multiplicateur de l'invention.

Selon l'invention, on utilise deux cellules de multiplication classiques identiques et un circuit additionneur. Un mode de réalisation du circuit multiplicateur selon l'invention est représenté à la figure 2. Il comporte deux cellules de multiplication C1 et C2 identiques à la cellule illustrée à la figure 1. Le signal sinusoïdal S1(t) est appliqué sur l'entrée E1 de la cellule de multiplication C1 et sur l'entrée E2 de la cellule de multiplication C2. A l'inverse, le signal sinusoïdal S2(t) est appliqué sur l'entrée E2 de la cellule de multiplication C1 et sur l'entrée E1 de la cellule de multiplication C2. Les signaux de sortie, notés O1(t) et 02(t), sont additionnés entre eux par un circuit additionneur ADD. Le signal obtenu à la sortie du circuit additionneur est donné par la formule suivante :

$$O(t)= A_1A_2*\sin(2wt-\varphi1-\varphi2)$$

$$+ (A_1A_2/2)*\sin(\varphi1-\varphi2)$$

$$+ (A_1A_2/2)*\sin(\varphi2-\varphi1) \text{ soit } O(t)= A_1A_2*\sin(2wt-\varphi1-\varphi2)$$

Le signal de sortie O(t) ne comporte plus de décalage en amplitude.

Pour que le circuit fonctionne correctement, il faut que les deux cellules de multiplication aient le même défaut.

C'est pourquoi, les cellules de multiplication C1 et C2 sont appairées et réalisées dans le même circuit intégré.

**Revendications**

**1.** Circuit multiplicateur de signaux sinusoïdaux apte à produire un signal sinusoïdal de sortie dépourvu de composante continue, comportant une première cellule de multiplication (C1) recevant sur une première entrée (E1) un premier signal sinusoïdal (S1(t)) et sur une deuxième entrée (E2) un second signal sinusoïdal (S2(t)), ladite première cellule de multiplication délivrant un premier signal de sortie (O1(t)), **caractérisé en ce qu'**il comporte en outre:

- une seconde cellule de multiplication (C2) identique à la première cellule de multiplication (C1) recevant sur sa première entrée (E1) le second signal sinusoïdal (S2(t)) et sur sa deuxième entrée (E2) le premier signal sinusoïdal (S1(t)) et délivrant un second signal de sortie (O2(t)), et
- un circuit additionneur (ADD) pour additionner lesdits premier et second signaux de sortie (O1(t),O2(t)) afin de générer un signal de sortie dépourvu de composante continue.

**2.** Circuit multiplicateur selon la revendication 1, **caractérisé en ce que** lesdites première et seconde cellules de multiplication (C1,C2) sont appairées et réalisées sur le même circuit intégré.

**FIG.1**

**FIG.2**

**EP 1 244 206 A1**

**RAPPORT DE RECHERCHE EUROPEENNE**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | EP 0 574 083 A (PHILIPS ELECTRONICS) 15 décembre 1993 (1993-12-15) * colonne 7, ligne 25 - colonne 14, ligne 15; figures 1,2 * | 1,2 | H03D3/00 |
| X | EP 0 370 539 A (N.V. PHILIPS GLOIELAMPENFABRIEKEN) 30 mai 1990 (1990-05-30) * colonne 3, ligne 33 - colonne 4, ligne 38; figures 3,4 * | 1,2 | |
| X | US 5 883 548 A (G, ASSARD) 16 mars 1999 (1999-03-16) * colonne 4, ligne 39 - colonne 6, ligne 17; figure 2 * | 1,2 | |
| X | DE 31 38 464 A (R. BOSCH GMBH) 14 avril 1983 (1983-04-14) * revendications 1-5; figure 1 * | 1,2 | |

**DOMAINES TECHNIQUES RECHERCHES (Int.Cl.7)**

H03D
H04L

Le présent rapport a été établi pour toutes les revendications

| Lieu de la recherche | Date d'achèvement de la recherche | Examinateur |
|---|---|---|
| LA HAYE | 12 juillet 2002 | Butler, N |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

5

**ANNEXE AU RAPPORT DE RECHERCHE EUROPEENNE
RELATIF A LA DEMANDE DE BREVET EUROPEEN NO.**  EP 02 36 4014

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

12-07-2002

| Document brevet cité au rapport de recherche | | Date de publication | Membre(s) de la famille de brevet(s) | | Date de publication |
|---|---|---|---|---|---|
| EP 574083 | A | 15-12-1993 | EP | 0574083 A1 | 15-12-1993 |
| | | | DE | 69313520 D1 | 09-10-1997 |
| | | | DE | 69313520 T2 | 26-02-1998 |
| | | | ES | 2109421 T3 | 16-01-1998 |
| | | | JP | 6069967 A | 11-03-1994 |
| | | | SG | 43971 A1 | 14-11-1997 |
| | | | US | 5341107 A | 23-08-1994 |
| EP 370539 | A | 30-05-1990 | NL | 8802531 A | 01-05-1990 |
| | | | EP | 0370539 A1 | 30-05-1990 |
| | | | JP | 2157667 A | 18-06-1990 |
| | | | US | 4970469 A | 13-11-1990 |
| US 5883548 | A | 16-03-1999 | AUCUN | | |
| DE 3138464 | A | 14-04-1983 | DE | 3138464 A1 | 14-04-1983 |
| | | | DE | 3274936 D1 | 05-02-1987 |
| | | | EP | 0080014 A2 | 01-06-1983 |
| | | | ES | 515944 D0 | 01-06-1983 |
| | | | ES | 8306551 A1 | 01-09-1983 |
| | | | JP | 1738997 C | 26-02-1993 |
| | | | JP | 4027723 B | 12-05-1992 |
| | | | JP | 58070606 A | 27-04-1983 |
| | | | US | 4506228 A | 19-03-1985 |

EPO FORM P0460

Pour tout renseignement concernant cette annexe : voir Journal Officiel de l'Office européen des brevets, No.12/82